# EUROPEAN PATENT APPLICATION

(11) **EP 4 575 530 A1**
(43) Date of publication of application: **25.06.2025**
(21) Application number: 23307348.5
(22) Date of filing: 22.12.2023
(51) Int. Cl.: G01R 31/27, G01R 31/28

(54) **A METHOD FOR EVALUATING AN ELECTRONIC COMPONENT FAULTINESS**

(71) Applicant: SCHNEIDER ELECTRIC INDUSTRIES SAS, 92500 Rueil-Malmaison (FR)
(72) Inventor: FERRY, Didier, 06510 LE BROC (FR); LENOTRE, Guillaume, 06110 LE CANNET (FR)
(74) Representative: Plasseraud IP

(57) **Abstract**

A method implemented by computer means for evaluating an electronic component on an electronic board, the method comprising the following steps:
(a) measuring an evolution overtime of a physical value of said component with a test machine, to obtain a first time series,
(b) defining a second time series corresponding to an evolution overtime of said physical value of said component without defects,
(c) calculating an error expressing the differences between both time series.

## Description

### Technical Field

This disclosure pertains to the field of electronics, more precisely to electronic components and their maintenance over faultiness.

### Background Art

In the dynamic landscape of manufacturing, the pursuit of operational excellence is a constant endeavor. As industries evolve, so do the challenges associated with maintaining the seamless functioning of production facilities.

A critical aspect of this pursuit is the management and maintenance of equipment, particularly in the realm of Printed Circuit Board Assembly (PCBA) production.

PCBA production, with its intricate processes and precision-driven requirements, demands a robust approach to equipment maintenance. Traditional maintenance strategies, whether reactive, planned, or proactive, have limitations in adapting to the evolving needs of a modern production environment.

### Summary

This disclosure improves the situation.

It is proposed a method implemented by computer means for evaluating an electronic component on an electronic board, the method comprising the following steps:
(a) measuring an evolution over time of a physical value of said component with a test machine, to obtain a first time series,
(b) defining a second time series corresponding to an evolution over time of said physical value of said component without defects,
(c) calculating an error expressing the differences between both time series.

The electric board, or PCBA, is the complete board after the electronic components have been mounted and soldered onto the PCB (Printed Circuit Board). The PCB is a flat board made of non-conductive material, usually fiberglass or composite epoxy, with conductive pathways etched or "printed" onto the board. These pathways, known as traces, form a circuit that connects electronic components mounted on the board. The primary function of a PCB is to provide a mechanically stable and electrically reliable platform for the assembly of electronic components.

The assembly process involves placing the components onto the PCB and then soldering them in place to establish electrical connections thus forming the electric board.

These electronic components may include resistors, capacitors, inductors, (light-emitting) diodes, switches, relays, transistors, microcontrollers, integrated circuit, crystal oscillators, connectors, fuses, sensors, etc.

At the step (a), a measured physical value corresponds to a real physical value of the component which may be its resistance (in Ohms) or conductance (in Ohms⁻¹), its voltage (in Volts), its current (in Amperes), its capacitance (in Farads), its inductance (in Henrys), its impedance (in Ohms), its power (in Watts), its gain etc.

When the circuit board includes a component using electric signals, it may also be a frequency (in Hertz), a duty-cycle, a Q-Factor, a phase angle (in Degrees), a noise level (in Decibels), etc.

A measured real physical value may also be environmental, for example a temperature (in Celsius for example) such as its inner temperature or the temperature of the air surrounding the component, and/or a humidity (in Grams per kilogram of dry air) or a relative humidity such as its inner humidity or the humidity of the air surrounding the component.

A physical value can vary over time; therefore, the step (a) may include measuring its evolution over time.

A time series hence may refer to a discrete measurement of the evolution: a sequence of data points that are ordered based on time. Each data point in the series corresponding to a measurement of the physical value may be associated with a specific time stamp, and the data may be collected or recorded at predefined intervals. These intervals may be constant (i.e. measurements are realized at a predefined frequency) or may vary linearly, logarithmically, exponentially, randomly, etc. The time span of the time series may expand over days.

Generally, the measurements are carried out on batches of electronic boards, which may comprise up to a thousand electronic boards.

Moreover, evolution of a plurality of physical values may be measured, successively or simultaneously. In that case, a first time series may be obtained respectively for each physical value.

In an embodiment, said plurality of physical values may comprise at least one of the electrical resistance, the electrical conductance, the capacitance, the impedance, the voltage, or the current of said component.

In an embodiment, said plurality of physical values may comprise at least one of the temperature, or the humidity of said component.

A test machine may include or correspond to a multimeter, an oscilloscope, a function generator, a LCR meter, a power meter, a spectrum analyzer, a logic analyzer, a thermal imaging camera, etc.

Preferably, a test machine may be an ad-hoc system that can directly measure all the components of a type of electronic board. For example, the test machine may include a plurality of measuring pins that make contact with the terminals of all the components to measure on an electronic board, when the test machine is facing and contacting said board. The board to measure may also provide measuring sockets to receive the pins, to assure a good connection.

Step (a) may pertain to a plurality of components, wherein identical physical values are measured across this diverse plurality of components.

Furthermore, step (a) may pertain to all components of an electronic board.

At step (b), a second time series corresponding to an evolution over time of said physical value of said component without defects may be defined.

A defect may correspond to an abnormal state making the component faulty. It may include open circuits, short circuits, abnormal high resistance, abnormal low resistance, capacitor leakage, capacitor shorts, inductor saturation, diode or transistor failures, faulty connections, temperature-related issues, mechanical damage, incorrect component values, contamination, aging or wear, signal interference, etc.

Said second time series hence may correspond to an evolution over time of said physical value of said component functioning in a nominal state.

Said second time series may be constructed based on theoretical models that articulate the expected behavior of the component in its nominal state.

In a preferred embodiment, at the step (b) the second time series may be constructed by a machine learning model, and preferably an unsupervised machine learning model.

For example, the step (b) may be realized by at least a part of a pretrained autoencoder machine learning model.

However, other unsupervised machine learning models such as Recurrent Neural Networks may be used.

An autoencoder is a type of artificial neural network designed for unsupervised learning that learns to encode and then reconstruct input data, aiming to capture essential features and reduce dimensionality. It consists of an encoder network that compresses input data into a latent representation or latent space, and a decoder network that reconstructs the original data from this representation.

The network is trained to minimize the difference between the input and the reconstructed output, enabling it to learn a condensed, meaningful representation of the data.

Types of autoencoders include the Vanilla Autoencoder, Sparse Autoencoder, and Variational Autoencoder (VAE). The Vanilla Autoencoder comprises an encoder and decoder, minimizing reconstruction loss to learn a compact representation. Sparse Autoencoder introduces sparsity constraints, encouraging the network to use only a subset of neurons for encoding, enhancing interpretability. Variational Autoencoder incorporates probabilistic elements, modeling data distribution and enabling generation of diverse samples.

In an embodiment, the autoencoder may be a VAE. VAEs introduce a latent space with a probabilistic interpretation, allowing for continuous and structured representation of data, making them particularly useful for generative tasks and data synthesis. VAEs may be therefore suitable for the construction of the second time series.

In an embodiment, the autoencoder may comprise an encoder and a decoder,
- Said encoder being able to take as input an evolution over time of a physical value of a component and output a latent space corresponding to said evolution, and
- Said decoder being able to take as input a latent space corresponding to an evolution over time of a physical value of a component and output a reconstruction of said evolution,
wherein the step (b) may be realized by said decoder of said autoencoder, said second time series being a reconstructed time series from a predetermined latent space corresponding to an evolution over time of said physical value of said component without defects.

The autoencoder may be advantageously trained with a training dataset of historical measurements. The training of the autoencoder may be unsupervised.

Preferably, the performance of the autoencoder may be verified with a validation dataset which may include labelled times series of measurements (of components with and without defects). A labeled dataset may refer to a set of data where the ground truth or correct outcomes are known, even though the algorithm itself is not trained on these labels during the unsupervised learning phase.

This labeled dataset may then be used to assess the performance of the unsupervised algorithm by comparing its results with the known labels.

An autoencoder model may be specific to a part of an electronic board or its entirety (i.e. all the electronic components of said part of the electronic board or said electronic board).

Therefore, a dataset may contain time series for each concerned components, for each measured physical values at step (a).

Hence, the input data of the encoder part of the autoencoder (and the reconstructed output data of the decoder part of the autoencoder) may be represented as a matrix with a dimension for the time, another one for the component, and another for the measured physical value.

In an embodiment, at step (c), the method may include calculating an error expressing the differences between both time series.

The error may be quantified through statistical calculations, serving as a measure to ascertain the presence of defects or abnormalities in a component.

In an embodiment, the step (c) may comprise calculating a statistical estimation based on an intrinsic tolerance of said component and a tolerance in the measurements of step (a).

The intrinsic tolerance, associated with the manufacturing process of the component, may be specified as the manufacturer's tolerance.

The measurements tolerance may represent potential imprecisions that may arise during the component measurement process.

Furthermore, upper and lower bounds may be established based on the component intrinsic tolerance and/or measurements tolerance. The error may be then monitored over time in relation to these defined bounds.

When a plurality of components is measured, an error may be calculated for each of the components and/or globally (one error for all the components).

When a plurality of physical values is measured, an error may be calculated for each of the physical values and/or globally (one error for all the physical values).

A drift of the error, relatively to a bound for example, may be observed as a gradual and continuous change in the magnitude or nature of the error over time. In the context of monitoring electronic components, it may indicate a deviation from the expected or nominal behavior. This drift may be observed in statistical calculations, and it may result from various factors such as a defect.

The error may also be quantified through an error function (or loss function) of the autoencoder.

The error function may be a reconstruction loss, which quantifies the difference between the input data and the output reconstructed by the autoencoder.

The error function may be Mean Squared Error (MSE), Binary Cross-Entropy Loss (BCE), Categorical Cross-Entropy Loss, Kullback-Leibler Divergence (KL Divergence), Huber Loss, and Smooth L1 Loss.

These loss functions may quantify the dissimilarity between the input data and the reconstructed output, guiding the training of autoencoders based on specific characteristics of the data.

The objective during training may be to minimize this reconstruction loss, encouraging the autoencoder to learn a compact and meaningful representation of the input data in the latent space. The lower the reconstruction loss, the better the autoencoder may be at capturing the essential features of the input and reproducing it accurately during decoding.

The step (c) may be realized by a calculator or a computer comprising a calculating unit and a memory stocking at least the time series (measured ones and reconstructed ones).

In an embodiment, the method may comprise the following step (d) estimating, from said error, whether said component could be faulty or not.

Based on the value of said error, the step (d) may conclude whether said component has a defect and is faulty (or not). For example, if the error is greater than a predefined threshold, or the drift is greater than a predefined threshold. This threshold may be also defined based on the component type, an intrinsic tolerance of the component and/or a tolerance of the measurements.

Furthermore, in an embodiment, the method may also comprise a step (e) wherein said component is replaced based on the result of step (d).

Replacing the component when it is faulty may be crucial to prevent further malfunctions of the electronic board. Addressing faulty components in a timely manner may not only ensure the continued functionality of the board but also safeguard other interconnected components from potential damage.

This proactive approach to maintenance may minimize downtime, reduce the risk of unexpected failures, and ultimately may contribute to the overall reliability and longevity of the electronic system.

In an embodiment, the steps (a), (b), (c) and (d) may be realized a plurality of times, for a same component and with different test machines, comprising a step (e) evaluating the origin of an estimated fault at step (d), from a plurality of estimations estimated at step (d).

Testing the electronic system multiple times using various test machines may enhance precision in error calculation and aids in identifying the root cause. This iterative testing approach may not only refine the accuracy of error measurements but also provides valuable insights into the specific components or subsystems contributing to the observed discrepancies. This may also facilitate targeted interventions and enhance the effectiveness of troubleshooting efforts.

For example, this may also target a defect in a specific test machine. Hence, the step (d) may further comprise estimating, from said error, whether one of said test machines could be faulty or not.

In another aspect of the invention, it is proposed a computer-readable non-transient recording medium on which a software is registered to implement the method when the software is executed by a processor.

In another aspect of the invention, it is proposed a computer program comprising instructions for implementing the method, when this program is executed by a processor.

In another aspect of the invention, it is proposed a computer system comprising a memory with the instructions of the computer program and a processor accessing to said memory to read the instructions and execute the method.

In another aspect of the invention, it is proposed a computer system comprising an input interface adapted to receive measurements of an evolution over time of a physical value of a component with a test machine, a memory with the instructions of the computer program and a processor accessing to said memory to read the instructions and execute the method, and an output interface adapted to indicate an error value corresponding to the component faultiness.

### Brief Description of Drawings

Other features, details and advantages will be shown in the following detailed description and on the figures, on which:
**Fig. 1**

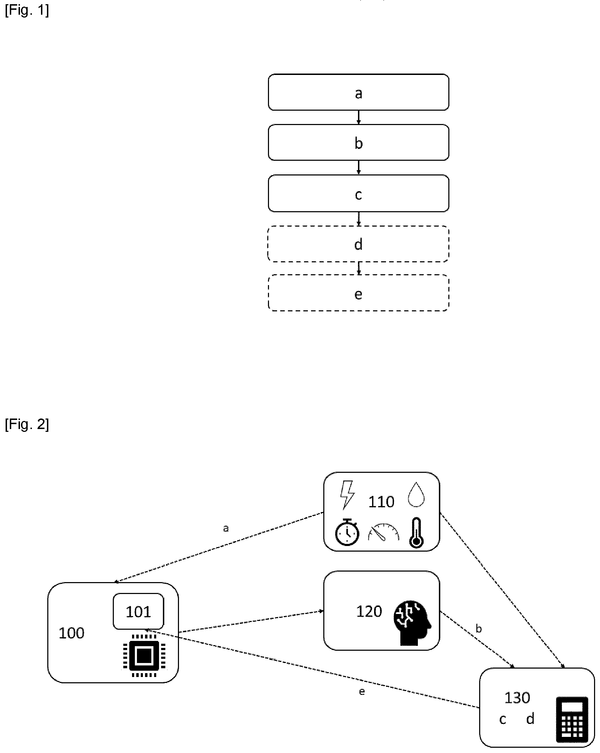

   [Fig. 1] depicts schematically a flow chart illustrating the method steps according to an embodiment.
**Fig. 2**
   [Fig. 2] depicts schematically an example of the realization of the method according to an embodiment.

### Description of a preferred embodiment

It is now referred to figure 1 depicting schematically a flow chart illustrating the method steps, and to figure 2 depicting schematically an example of the realization of the method according to an embodiment.

In this embodiment, the method may pertain to an electronic component 101 of an electronic card 100.

The step (a) may be realized by a test machine 110 on electronic components 101 of an electronic card 100.

The test machine 110 may be designed to measure all the electronic components 101 simultaneously.

The measurements realized by the test machine 110 on the components 101 may be measurements of real physical values including resistance, voltage, current, capacitance, inductance, temperature, and relative humidity.

A first plurality of time series is then built from the measurements: for each of the components 101 and for each of the measured physical values.

Based on the type of electronic board 100 and/or the electronic components 101 measured during step (a), an autoencoder machine learning model 120 may be determined.

This machine learning model 120 may reconstruct during step (b), from a predefined latent space corresponding to a non-faulty behavior of the electronic board, time series of measurements of the components 101 without defects. A time series of measurements may then be reconstructed for each of the components 101.

Time series may be respectively compared by a calculator 130. During step (c), the calculator 130 calculates an error for every component and every physical value between the measured time series relatively to the reconstructed time series. The error may be calculated following a Mean Square Error (MSE) reconstruction loss function.

For each component, a tolerance for every measured physical value, considering both its intrinsic tolerance and a measurement tolerance, may be calculated. This may also involve establishing corresponding upper and lower bounds relative to the reconstructed time series.

Based on these bounds, a component 101 may be evaluated as faulty during step (d), when a measured value is out of the bounds.

Based on the errors calculated, a component (or a plurality of them) may be evaluated as faulty during step (d), when a drift of an error (or a plurality of them) is observed.

The step (a), (b), (c), and (d) may be realized a plurality of times with different test machines 110 on the same components 101 of the same electronic board (100).

A component may be evaluated as faulty based on the evaluations resulting of the plurality of steps (d).

During step (e), a component evaluated as faulty may be replaced by a new one.

## Claims

1. A method implemented by computer means for evaluating an electronic component on an electronic board, the method comprising the following steps:
(a) measuring an evolution over time of a physical value of said component with a test machine, to obtain a first time series,
(b) defining a second time series corresponding to an evolution over time of said physical value of said component without defects,
(c) calculating an error expressing the differences between both time series.

2. The method according to claim 1 comprising the following step:
(d) estimating, from said error, whether said component could be faulty or not.

3. The method according to the claim 1 or 2 wherein step (c) comprises calculating a statistical estimation based on an intrinsic tolerance of said component and a tolerance in the measurements of step (a).

4. The method according to claim 2 or 3 wherein the steps (a), (b), (c) and (d) are realized a plurality of times, for a same component and with different test machines, comprising a step (e) evaluating the origin of an estimated fault at step (d), from a plurality of estimations estimated at step (d).

5. The method according to the preceding claim wherein the step (d) further comprises estimating, from said error, whether one of said test machines could be faulty or not.

6. The method according to any preceding claim wherein the step (b) is realized by at least a part of a pretrained autoencoder machine learning model.

7. The method according to the preceding claim wherein the autoencoder is a VAE.

8. The method according to the claim 5 or 6 wherein said autoencoder comprises an encoder and a decoder,
- Said encoder being able to take as input an evolution over time of a physical value of a component and output a latent space corresponding to said evolution, and
- Said decoder being able to take as input a latent space corresponding to an evolution over time of a physical value of a component and output a reconstruction of said evolution,
wherein the step (b) is realized by said decoder of said autoencoder, said second time series being a reconstructed time series from a predetermined latent space corresponding to an evolution over time of said physical value of said component without defects.

9. The method according to any preceding claim wherein:
- the step (a) comprises measuring evolutions over time of a plurality of physical values of said component with said test machine, to obtain a first plurality of time series,
- the step (b) comprises defining a second plurality of time series corresponding to the evolutions over time of said plurality of physical values of said component without defects,
- the step (c) comprises calculating an error expressing the respective differences between both pluralities of time series.

10. The method according to the preceding claim wherein said plurality of physical values comprises at least one of the electrical resistance, the electrical conductance, the capacitance, the impedance, the voltage, or the current of said component.

11. The method according to the preceding claim wherein said plurality of physical values comprises at least one of the temperature, or the humidity of said component.

12. The method according to any of the claims 2 to 9 further comprising a step (e) wherein said component is replaced based on the result of step (d).

13. Computer-readable non-transient recording medium on which a software is registered to implement a method according to any of the preceding claims when the software is executed by a processor.

14. Computer program comprising instructions for implementing the method according to one of the claims 1 to 11, when this program is executed by a processor.

15. Computer system comprising a memory with the instructions of a computer program according to the preceding claim and a processor accessing to said memory to read the instructions and execute the method according to the claims 1 to 11.
